Europäisches Patentamt

European Patent Office

Office européen des brevets

(11) Publication number: **0 162 605**
**B1**

(12) **EUROPEAN PATENT SPECIFICATION**

(45) Date of publication of patent specification: **20.06.90**

(21) Application number: **85302931.2**

(22) Date of filing: **25.04.85**

(51) Int. Cl.⁵: **G 09 G 3/28, H 03 K 5/153,**
**H 03 K 5/26, H 04 N 3/14**

(54) Sequential selection circuits.

(30) Priority: **25.04.84 JP 83330/84**

(43) Date of publication of application:
**27.11.85 Bulletin 85/48**

(45) Publication of the grant of the patent:
**20.06.90 Bulletin 90/25**

(84) Designated Contracting States:
**DE FR GB IT**

(56) References cited:
**DE-B-2 117 454**
**DE-B-2 729 419**
**JP-A-58 107 022**
**US-A-4 200 868**
**US-A-4 247 856**
**US-A-4 352 995**

**PROCEEDINGS OF THE S.I.D., vol. 21, no. 2,
1980, pages 107-111, Los Angeles, US; K.
KASANO et al.: "A 240-character vacuum
fluorescent display and its drive circuitry"**

(73) Proprietor: **SONY CORPORATION**
**7-35 Kitashinagawa 6-Chome Shinagawa-ku**
**Tokyo 141 (JP)**

(72) Inventor: **Shionoya,Toshio c/o Sony**
**Corporation**
**Patent Division 7-35 Kitashinagawa 6-chome**
**Shinagawa-ku Tokyo (JP)**

(74) Representative: **Cotter, Ivan John et al**
**D. YOUNG & CO. 10 Staple Inn**
**London WC1V 7RD (GB)**

## Description

This invention relates to sequential selection circuits.

Plasma display panels of an X—Y matrix type are known as a means for displaying characters or images. An X-electrode group (data electrodes) comprises anodes to which high and low voltages are applied according to the display data, i.e. the data to be displayed. A Y-electrode group (scanning electrodes) comprise cathodes which are scanned in a line sequential manner with a negative voltage pulse being applied.

A cathode scanning circuit comprises a shift register having the same number of shift stages as the number of cathodes and a group of drive transistors which are turned on sequentially in response to outputs from respective stages of the shift register so as to apply voltages to the cathodes. If it is assumed that a pulse of a cathode scanning period is an H pulse, which is a horizontal scanning pulse, and a pulse of one frame period (one frame) is a V pulse which is a vertical scanning pulse, the shift register receives a V pulse of high level and transfers it sequentially to succeeding stages using the H pulses as clock signals. Since the V pulse returns to a low level immediately after being received by the shift register, single items of data always are shifted in the shift register through the stages one by one so that the cathodes are activated sequentially.

However, if the V pulse of high level has an abnormally long pulse width or if the V pulse becomes fixed at a high level due to short circuiting of a circuit or element, a plurality of stages in the shift register will be set simultaneously to "1" and a plurality of cathodes will be selected at the same time. In this event, the problem arises that current through the discharge cells will be considerably increased and power supply units or drive transistors of cathode drive circuitry can be damaged.

US Patent No. US—A—4 247 856 discloses a plasma display device which includes a plasma screen discharge tube having rows and columns. A shift register type logic circuit has taps connected to the columns of the screen so as to sweep the columns in sequence periodically. The shift register type logic circuit is driven by, and at a rate determined by, clock pulses from a clock generator. A timing signal generator drives the clock generator and three cascaded counters. Outputs of the counters control a character generator which supplies a controlled logic circuit connected to the rows of the screen. Each time the third counter in the cascade supplies an output, which occurs once for each complete row of displayed characters, the characters generator feeds binary signals relating to the characters in each column to a shift register in the controlled logic circuit.

According to a first aspect of the invention there is provided a sequential selection circuit for selecting a series of circuits, elements, electrodes or other items over a long period to activate them sequentially one by one for a short period, the sequential selection circuit comprising a shift register which has a number of shift stages corresponding to the total number that is to be selected for sequentially shifting a single input pulse in response to clock pulses corresponding to the short period, a counter for counting the clock pulses so as to generate a pulse output when a count reaches the total selection number, an input circuit for generating an input pulse for the shift register in accordance with the pulse output from the counter and a pulse corresponding to the long period, and a reset circuit for resetting the counter in accordance with the clock pulse and the pulse corresponding to the long period.

According to a second aspect of the invention there is provided a sequential selection circuit for a plasma display device for selecting and energising a plurality of electrodes so as sequentially to generate a number of displays for a short period over a relatively long period to produce a composite display, the sequential selection circuit comprising a shift register which has a number of shift stages corresponding to the number of displays for a short period so as sequentially to shift a single display pulse in response to clock pulses corresponding to the short period, a counter operative to receive and count the clock pulses and to generate an output pulse when the count reaches the number of displays for a short period, an input circuit for the shift register, the input circuit being connected to receive the output pulse of the counter and a pulse which corresponds to the long period, and a reset circuit for the counter, the reset circuit being connected to receive the clock pulse and the pulse which corresponds to the long period.

A preferred embodiment of the present invention described hereinbelow seeks to solve the above-mentioned problem by satisfactorily performing sequential selection without damage to associated circuit element or components.

The invention will now be further described, by way of illustrative and non-limiting example, with reference to the accompanying drawings, in which:—

Figure 1 is a schematic plan view of a plasma display panel to which a sequential selection circuit embodying the present invention can be applied;

Figure 2 is a sectional view of a portion of the panel of Figure 1;

Figure 3 is a circuit diagram of a cathode scanning circuit for the plasma display panel;

Figure 4 is a circuit diagram of an input protection circuit for a shift register of the circuit shown in Figure 3;

Figures 5A to 5F are waveforms for illustrating operation of the circuits of Figures 3 and 4; and

Figure 6A to 6F are waveforms illustrating a timing chart for explaining the operation of the circuits of Figures 3 and 4.

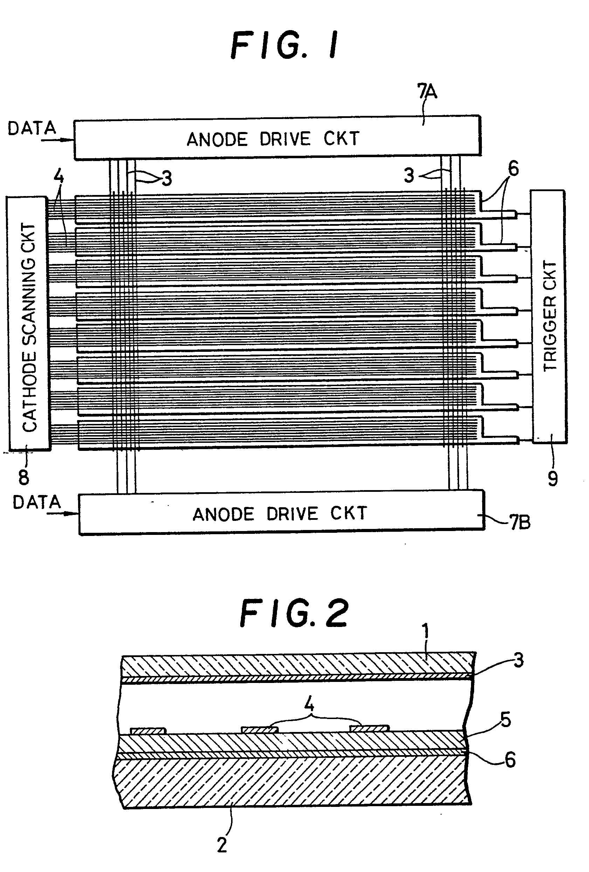

Figure 1 is a schematic plan view of a plasma display panel (PDP) which has a sequential selection circuit that may embody the present invention. Figure 2 is a partial sectional view of the panel illustrated in Figure 1. The plasma display panel comprises a front glass panel 1 and a rear glass panel 2 with anodes 3 (which are data electrodes) and cathodes 4 (which are scanning electrodes) sandwiched between the glass panels 1 and 2. The glass panels 1 and 2 are sealed together and the anodes 3 and cathodes 4 are arranged in a X—Y matrix with small discharge gaps formed between them. Trigger eletrodes 6 are divided into a plurality of phases (such as eight phases) and are arranged under and along and parallel to the cathodes 4.

Alternate anodes 3 are coupled together. A first group of the alternate electrodes 3 are coupled to an upper anode driver 7A and the other alternate group of anodes are connected to a lower anode driver 7B. A data voltage of high level such as "1" or low level such as "0", corresponding to the display data (data to be displayed), is applied to the anodes 3, in synchronism with a cathode scanning voltage, through a shift register which produces a parallel output and a switching output element of the drivers 7A and 7B according to the data diplay input, which is in serial form.

A negative voltage is applied to the cathodes 4 by a cathode scanning circuit 8 from an upper edge to a lower edge in a line sequential manner. A discharge is generated between a selected cathode 4 and the anode 3 to which a high voltage is applied.

The trigger electrodes 6 are driven by a trigger circuit 9 in a phase sequential manner, high trigger voltage pulses being supplied to the trigger electrodes 6 in an active phase in synchronism with the timing of the cathode scanning. Trigger discharges are generaated between the trigger electrodes 6 and the associated cathodes 4: a breakdown voltage between an anode and a cathode is decreased by spatial ions due to this discharge, thereby inducing a main discharge between the anode and the cathode.

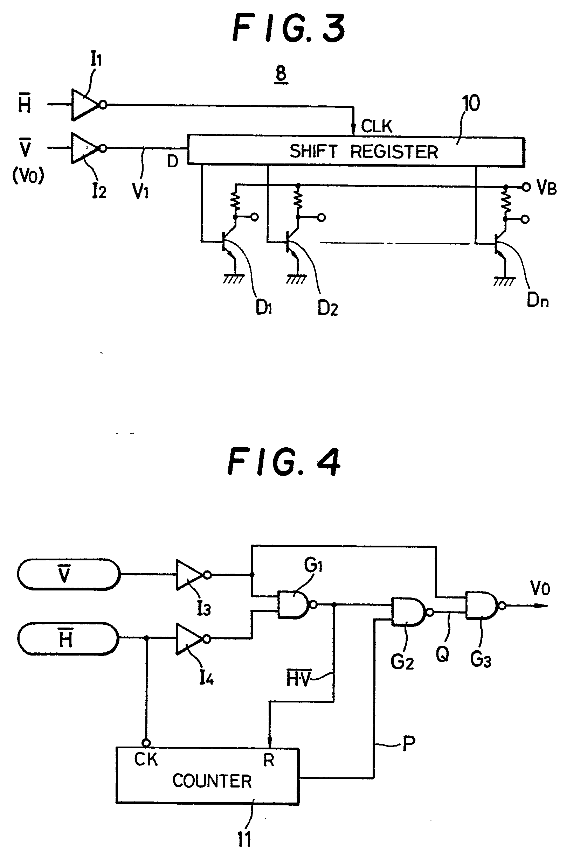

As shown in Figure 3, the cathode scanning circuit 8 comprises a shift register 10 which has the same number of shift stages as there are cathodes 4. Cathode drive transistors D1, D2, . . . Dn are connected to outputs of the shift register to be turned on respectively by outputs from the respective shift stages. The cathodes 4 are connected to corresponding collectors of the transistors D1 to Dn. Each time a selected transistor is turned on, ground potential is applied to a selected one of the cathodes 4. The cathodes 4 which are not selected are maintained at a positive bias voltage $V_B$. Thus, even when a data voltage is applied to the anode 3 which is opposite the non-selected cathode line, the cell will not generate a discharge.

Horizontal pulses H of a cathode scanning period corresponding to a horizontal scanning period, as illustrated in Figure 5B, are supplied as a clock input CLK to the shift register 10 through an inverter $I_1$. A vertical pulse V of a frame period corresponding to a vertical scanning period, as illustrated in Figure 5A, is supplied to a data input D of the shift register 10 through an inverter $I_2$. The V pulse is received by the shift register at the beginning of a frame and is shifted sequentially at the clock period, thereby sequentially supplying an output "1" to the transistors $D_1$ to $D_n$.

In the event that a malfunction occurs, such that the V pulse decreases to a low level, the data input D of the shift register 10 will be maintained at a high level and all the outputs from the shift register will be set to "1". This can damage a cathode driver and/or a power supply due to overloading.

According to an embodiment of the invention, this problem is solved by a protection circuit illustrated in Figure 4, which is connected to the circuit of Figure 3. To solve the problem, the V pulse is applied to the shift register through the protection circuit of Figure 4. The protection circuit comprises a counter 11 which has the same count number as there are cathodes, which in a particular example may be 400. The H pulse is supplied to a clock input CK of the counter 11. A negative logic AND signal H.V (Figure 5C), which is a combination of the H and V pulses illustrated in Figures 5A and 5B, is supplied to a reset input R of the counter 11 through inverters 13 and 14 and a NAND-gate G1.

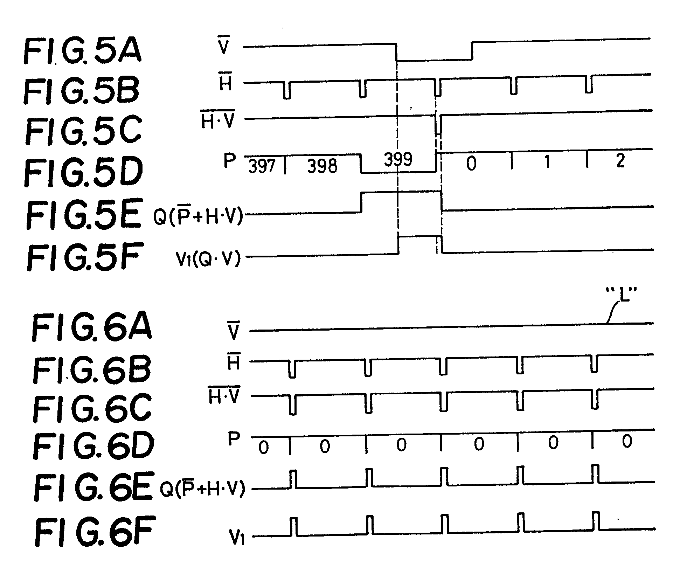

The counter 11 generates a low level output (Figure 5D) which comprises a pulse P at the count "399". The counter 11 is reset by the reset pulse $\overline{H.V}$ (Figure 5C) so as to generate a high level of a count "0". The count output P is supplied to a NAND-gate G2 to gether with the output $\overline{H.V}$ of the NAND-gate G1 and generates a pulse Q (Figure 5E) which is the ORed output of the inverted form $\overline{P}$ of the pulse P and the inverted form H.V of the pulse $\overline{H.V}$. The pulse Q is supplied to a NAND-gate G3 together with the output V of the inverter 13 so as to form a pulse output signal $V_o$ ($\overline{Q.V}$) shown in Figure 5F. The output pulse $V_o$ is supplied to the data input D of the shift register 10 illustrated in Figure 3 through the inverter $I_2$ as a pulse V1 (Q.V), which is illustrated in Figure 5F. This pulse is applied to the input D in Figure 3 instead of the V pulse which would be applied in the absence of the protection circuit of Figure 4.

As a result of the presence of the protection circuit of Figure 4, inputs are supplied to the shift register for each V period (which is the frame period) and are shifted sequentially.

Figures 6A to 6F illustrate that, when a malfunction occurs such that the V pulse ($\overline{V}$) illustrated in Figure 6A becomes of fixed level and maintains a low level "L", then the reset pulse applied to the rest input of the counter 11 at each reception of an H pulse is as shown in Figure 6C ($\overline{H.V}$). Thus, the counter 11 will always be reset and the count will not be incremented; in other words, it will be kept at "0". For this reason, the count output will be at a high level as illustrated in Figure 6D by the line P. The output Q from the NAND-gate G2 then becomes the pulse H.V, which is the inverted form of the reset pulse $\overline{H.V}$. The input pulse V1, which is generated by the NAND-gate G3 and the inver-

ter $I_2$ and which is applied to the shift register 10, will be the same as the pulse Q illustrated in Figure 6F and designed as V1.

The input pulse V1 is formed in the protection circuit in that the H pulse ($\overline{H}$) passes through the inverter 4, the NAND-gates G1, G2, and G3 illustrated in Figure 4 and the inverter $I_2$ illustrated in Figure 3. For this reason, the leading edge of the input pulse V1 will be delayed slightly with respect to that of the H pulse. Therefore, the shift register 10 does not receive the input pulse V1 as data and all of the outputs are kept at a low level. Thus, a plurality of the cathodes 4 will not be turned on at the same time.

In the embodiment described above, the logic circuits I3, I4, G1, G2 and G3 which constitute the protection circuit of Figure 4 can be replaced by a read only memory (ROM) which can accomplish the same results.

Thus, the present arrangements provides a protection circuit for a plasma display panel (or other device) which prevents the shift register from sequentially reading erroneous inputs and producing a plurality of shift stage outputs at the same time. This prevents selected circuits, elements, electrodes and drive circuits and power supplies from being damaged.

**Claims**

1. A sequential selection circuit for selecting a series of circuits, elements, electrodes or other items over a long period to activate them sequentially one by one for a short period, the sequential selection circuit comprising a shift register (10) which has a number of shift stages corresponding to the total number that is to be selected for sequentially shifting a single input pulse in response to clock pulses (H) corresponding to the short period, a counter (11) for counting the clock pulses (H) so as to generate a pulse output (P) when a count reaches the total selection number, an input circuit (G1, G2, G3) for generating an input pulse ($V_1$) for the shift register (10) in accordance with the pulse output (P) from the counter (11) and a pulse (V) corresponding to the long period, and a reset ciruit (G1) for resetting the counter (11) in accordance with the clock pulse (H) and the pulse (V) corresponding to the long period.

2. A sequential selection circuit for a plasma display device for selecting and energising a plurality of electrodes so as sequentially to generate a number of displays for a short period over a relatively long period to produce a composite display, the sequential selection circuit comprising a shift register (10) which has a number of shift stages corresponding to the number of displays for a short period so as sequentially to shift a single display pulse in response to clock pulses (H) corresponding to the short period, a counter (11) operative to receive and count the clock pulses (H) and to generate an output pulse (P) when the count reaches the number of displays for a short period, an input circuit (G1, G2, G3) for the shift register (10), the input circuit being connected to receive the output pulse (P) of the counter (11) and a pulse (V) which corresponds to the long period, and a reset circuit (G1) for the counter (11), the reset circuit being connected to receive the clock pulse (H) and the pulse (V) which corresponds to the long period.

3. A sequential selection circuit according to claim 2, wherein the input circuit (G1, G2, G3) for the shift register (10) comprises a first NAND-gate (G1) connected to receive the clock pulse (H) and the pulse (V) which corresponds to the long period, a second NAND-gate (G2) connected to receive the output (P) of the counter (11) and an output of the first NAND-gate (G1), and a third NAND-gate (G3) connected to receive the clock pulse (H) and an output of the second NAND-gate (G2).

4. A sequential selection circuit according to claim 3, wherein the reset circuit (G1) includes the first NAND-gate (G1), which is operative to produce a reset pulse for the counter (11).

5. A sequential selection circuit according to claim 2, claim 3 or claim 4, wherein the clock pulse (H) corresponds to a horizontal scanning frequency of the display device and the long period (V) comprises to a vertical scanning period of the display device.

**Patentansprüche**

1. Sequentielle Auswahlschaltung für die Auswahl einer Reihe von Schaltungen, Elementen, Elektroden oder anderen Gegenständen über eine lange Periode und zu ihrer einzeln nacheinander mit kurzer Periode erfolgenden Aktivierung,

mit einem Schieberegister (10) mit einer Anzahl von Registerstufen, die der Gesamtzahl entspricht, die für die sequentielle Verschiebung eines einzelnen Eingangsimpulses in Abhängigkeit von der genannten kurzen Periode entsprechenden Taktimpulsen (H) auszuwählen ist,

mit einem Zähler (11) zum Abzählen der Taktimpulse (H) und zur Erzeugung eines Impulsausgangssignals (P), wenn sein Zählstand die ausgewählte Gesamtzahl erreicht,

mit einer Eingangsschaltung (G1, G2, G3) zur Erzeugung eines Eingagsimpulses ($V_1$) für das Schieberegister (10) in Abhängigkeit von dem Impulsausgangssignal (P) des Zählers (11) und einem de langen Periode entsprechenden Impuls (V),

sowie mit einer Rücksetzschaltung (G1) zum Rückstellen des Zählers (11) in Abhängigkeit von dem Taktimpuls (H) und dem der langen Periode entsprechenden Impuls (V).

2. Sequentielle Auswahlschaltung für ein Plasmadisplay zur Auswahl und Aktivierung einer Mehrzahl von Elektroden derart, daß zur Erzeugung einer zusammengesetzten Darstellung über eine relativ lange Periode sequentiell eine Anzahl von Darstellungen mit kurzer Periode erzeugt wird,

mit einem Schieberegister (10) mit einer der Anzahl der genannten Darstellungen mit kurzer Periode entsprechenden Zahl von Registerstufen zur sequentiellen Verschiebung eines einzelnen Anzeigeimpulses in Abhängigkeit von der kurzen Periode entsprechenden Taktimpulsen (H),

mit einem Zähler (11), der die Taktimpulse (H) aufnimmt und abzählt und einen Ausgagnsimpuls erzeugt, (P), wenn sein Zählstand die Zahl der Anzeigen für eine kurze Periode erreicht,

mit einer Eingangsschaltung (G1, G2, G3) für das Schiebereigster (10), die den Ausgangsimpuls (P) des Zählers (11) und einen der langen Periode entsprechenden Impuls (V) aufnimmt,

sowie mit einer Rücksetzschaltung (G1) für den Zähler (11), die den Taktimpuls (H) und den der langen Periode entsprechenden Impuls (V) aufnimmt.

3. Sequentielle Auswahlschaltung nach Anspruch 2, bei der die Eingangsschaltung (G1, G2, G3) für das Schiebereigster (10) ein erstes NAND-Glied (G1) enthält, das den Taktimpuls (H) und den der langen Periode entsprechenden Impuls (V) aufnimmt, ferner eine zweites NAND-Glied (G2), das den Ausgangsimpuls (P) des Zählers (11) und das Ausgangssignal des ersten NAND-Glieds (G1) aufnimmt, sowie ein drittes NAND-Glied (G3), das den Taktimpuls (H) und das Ausgangssignal des zweiten NAND-Glieds (G2) aufnimmt.

4. Sequentielle Auswahlschaltung nach Anspruch 3, bei der die Rücksetzschaltung (G1) das erste NAND-Glied (G1) enthält, das einen Rücksetzimpuls für den Zähler (11) erzeugt.

5. Sequentielle Auswahlschaltung nach Anspruch 2, 3 oder 4, bei der die Taktimpuls (H) der horizontalen Abtastfrequenz des Displays entspricht und die lange Periode (V) der vertikalen Abtastperiode des Displays entspricht.

**Revendications**

1. Circuit de sélection séquentielle servant à sélectionner une série de circuits, d'éléments, d'électrodes ou d'autres éléments sur une longue durée afin de les activer séquentiellement l'un après l'autre pendant une brève durée, le circuit de sélection séquentielle comprenant un registre à décalage (10) qui posséde un nombre d'étages de décalage correspondant au nombre total qui doit être sélectionné pour décaler séquentiellement une unique impulsion d'entrée en réponse à des impulsions d'horloge (H) correspondant à la durée brève, un compteur (11) servant à compter les impulsions d'horloge (H) de manière à produire une impulsion de sortie (P) lorsqu'une valeur de comptage atteint le nombre de sélections total, un circuit d'entrée (G1, G2, G3) servant à produire une impulsion d'entrée (V₁) destinée au registre à décalage (10) en fonction de l'impulsion de sortie (P) du compteur (11) et d'une impulsion (V) correspondant à la durée longue, et un circuit de repositionnement (G1) servant à repositionnement le compteur (11) en fonction de l'impulsion d'horloge (H) et de l'impulsion (V) correspondant à la durée longue.

2. Circuit de sélection séquentielle pour dispositif d'affichage à plasma servant à sélectionner et exciter plusieurs électrodes de façon à produire séquentiellement un certain nombre d'affichages ayant une brève durée sur une durée relativement longue de manière à produire un affichage composite, le circuit de sélection séquentielle comprenant un registre à décalage (10) qui posséde un nombre d'étages de décalage correspondant au nombre des affichages ayant une durée brève de façon à séquentiellement décaler une unique impulsion d'affichage en réponse à des impulsions d'horloge (H) correspondant à la durée brève, un compteur (11) ayant pour fonction de recevoir et de compter les impulsions d'horloge (H) et de produire une impulsion de sortie (P) lorsque la valeur de comptage atteint le nombre d'affichages ayant un durée brève, un circuit d'entrée (G1, G2, G3) pour le registre à décalage (10), le circuit d'entrée étant connecté de façon à recevoir l'impulsion de sortie (P) du compteur (11) et une impulsion (V) qui correspond à la durée longue, et un circuit de repositionnement (G1) du compteur (11), le circuit de repositionnement étant connecté de façon à recevoir l'impulsion d'horloge (H) et l'impulsion (V) qui correspond à la durée longue.

3. Circuit de sélection séquentielle selon la revendication 2, où le circuit d'entrée (G1, G2, G3) du registre à décalage (10) comprend une première porte NON-ET (G1) connectée de façon à recevoir le signal d'horloge (H) et l'impulsion (V) qui correspond à la durée longue, une deuxième porte NON-ET (G2) connectée de façon à recevoir le signal de sortie (P) du compteur (11) et un signal de sortie de la première porte NON-ET (G1), et une troisième porte NON-ET (G3) connectée de façon à recevoir l'impulsion d'horloge (H) et un signal de sortie de la deuxième porte NON-ET (G2).

4. Circuit de sélection séquentielle selon la revendication 3, où le circuit de repositionnement (G1) comporte la première porte NON-ET (G1), qui a pour fonction de produire une impulsion de repositionnement à destination du compteur (11).

5. Circuit de sélection séquentielle selon la revendication 2, 3 ou 4, où l'impulsion d'horloge (H) correspond à une fréquence de balayage horizontal du dispositif d'affichage et la durée longue (V) comprend une période de balayage vertical du dispositif d'affichage.

# FIG. 1

7A

DATA →

ANODE DRIVE CKT

CATHODE SCANNING CKT

4

3

3

6

TRIGGER CKT

8

9

DATA →

ANODE DRIVE CKT

7B

# FIG. 2

1

3

4

5

6

2

# F I G. 3

# F I G. 4

EP 0 162 605 B1

FIG.5A  $\overline{V}$

FIG.5B  $\overline{H}$

FIG.5C  $\overline{H \cdot V}$

FIG.5D  P  397 | 398 | 399 | 0 | 1 | 2

FIG.5E  $Q(\overline{P} + H \cdot V)$

FIG.5F  $V_1(Q \cdot V)$

FIG.6A  $\overline{V}$  "L"

FIG.6B  $\overline{H}$

FIG.6C  $\overline{H \cdot V}$

FIG.6D  P  0 | 0 | 0 | 0 | 0 | 0

FIG.6E  $Q(\overline{P} + H \cdot V)$

FIG.6F  $V_1$

3